# DEMANDE DE BREVET EUROPEEN

(11) **EP 3 173 829 A1**
(43) Date de publication de la demande: **31.05.2017**
(21) Numéro de dépôt: 16200330.5
(22) Date de dépôt: 23.11.2016
(51) Int. Cl.: G02B 5/20

(54) **FILTRE PLASMONIQUE**

(30) Priorité: 27.11.2015 FR 1561454
(71) Demandeur: STmicroelectronics SA, 92120 Montrouge (FR); STMicroelectronics (Crolles 2) SAS, 38920 Crolles (FR); COMMISSARIAT À L'ÉNERGIE ATOMIQUE ET AUX ÉNERGIES ALTERNATIVES, 75015 Paris (FR)
(72) Inventeur: GIRARD DESPROLET, Romain, 38000 GRENOBLE (FR); LHOSTIS, Sandrine, 38570 THEYS (FR); BOUTAMI, Salim, 38100 GRENOBLE (FR)
(74) Mandataire: Thibon, Laurent

(57) **Abrégé**

L'invention concerne un filtre plasmonique (1) passe-haut dans l'infrarouge comprenant, à travers une couche de cuivre (3) intercalée entre deux couches d'un matériau diélectrique, une matrice de motifs (9) en le matériau diélectrique, chaque motif étant en forme de croix grecque, les bras (11, 13) de motifs adjacents étant colinéaires, le rapport de la largeur (B) sur la longueur (A) de chaque bras étant compris entre 0,3 et 0,6, et la distance (D) séparant les extrémités en vis-à-vis de bras de motifs adjacents étant inférieure à 10 nm.

## Description

### Domaine

La présente demande concerne un filtre plasmonique de type passe-haut adapté à laisser passer la lumière infrarouge et bloquer la lumière visible.

### Exposé de l'art antérieur

Les filtres plasmoniques comprennent un motif en un matériau diélectrique s'étendant à travers une couche métallique ou l'inverse, le motif étant généralement répété de manière périodique dans cette couche.

La demande de brevet WO 2010/029097 décrit un exemple de filtre plasmonique comprenant un motif cruciforme en un matériau diélectrique répété périodiquement dans une couche métallique. Ce filtre est de type passe-bande étroit, c'est-à-dire que la plage de longueurs d'onde pour laquelle le filtre laisse passer plus de 50 % de la lumière reçue a une largeur inférieure à une centaine de nanomètres.

Dans certaines applications, notamment dans le domaine des capteurs d'images, lorsque l'on souhaite réaliser un filtre passe-haut bloquant la lumière visible et laissant passer la lumière infrarouge, on utilise une couche d'un matériau, couramment appelé résine noire, absorbant la lumière visible et transparent à la lumière infrarouge. Toutefois, l'emploi de résine noire pose divers problèmes, notamment du fait que la résine noire se dégrade lorsqu'elle est soumise à des températures supérieures à 250°C ce qui rend difficile, une fois le dépôt de la résine noire effectué, la réalisation d'autres structures qui impliquent des traitements thermiques. De plus, il est difficile de délimiter de la résine noire sur de petites surfaces correspondant à des pixels élémentaires.

Il serait donc souhaitable de disposer d'un filtre passe-haut laissant passer la lumière infrarouge et bloquant la lumière visible, n'utilisant pas de couche absorbante de type résine noire.

### Résumé

Ainsi, un mode de réalisation prévoit un filtre plasmonique passe-haut dans l'infrarouge comprenant, à travers une couche de cuivre intercalée entre deux couches d'un matériau diélectrique, une matrice de motifs en le matériau diélectrique, chaque motif étant en forme de croix grecque, les bras de motifs adjacents étant colinéaires, le rapport de la largeur sur la longueur de chaque bras étant compris entre 0,3 et 0,6, et la distance séparant les extrémités en vis-à-vis de bras de motifs adjacents étant inférieure à 10 nm.

Selon un mode de réalisation, l'épaisseur de la couche de cuivre est comprise entre 50 et 500 nm.

Selon un mode de réalisation, l'indice optique du matériau diélectrique est compris entre 1,3 et 2,3.

Selon un mode de réalisation, le matériau diélectrique est du nitrure de silicium.

Selon un mode de réalisation, la longueur des bras est comprise entre 70 et 195 nm.

Selon un mode de réalisation, la distance est comprise entre 3 et 7 nm.

Selon un mode de réalisation, le rapport est compris entre 0,35 et 0,55.

Un autre mode de réalisation prévoit un capteur d'image comprenant, dans et sur une portion de couche semiconductrice, au moins un premier pixel destiné à recevoir de la lumière visible et au moins un deuxième pixel destiné à recevoir de la lumière infrarouge, chaque premier pixel étant surmonté d'un filtre plasmonique passe-bande dans le visible et chaque deuxième pixel étant surmonté d'un filtre plasmonique passe-haut dans l'infrarouge tel que susmentionné.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A et 1B représentent schématiquement un mode de réalisation d'un filtre plasmonique passe-haut dans l'infrarouge ;
les figures 2 à 5 illustrent le taux de transmission normalisé en fonction de la longueur d'onde pour des filtres du type de celui des figures 1A et 1B ; et
la figure 6 représente schématiquement un exemple de dispositif comprenant un filtre du type de celui des figures 1A et 1B.

### Description détaillée

De mêmes éléments ont été désignés par de mêmes références dans les différentes figures qui, par ailleurs, ne sont pas tracées à l'échelle. Par souci de clarté, seuls les éléments qui sont utiles à la compréhension des modes de réalisation décrits ont été représentés et sont détaillés.

Dans la description qui suit, les termes "supérieur" et "inférieur" se réfèrent à l'orientation des éléments concernés dans les figures correspondantes. Sauf précision contraire, l'expression "de l'ordre de" et les termes "sensiblement" et "environ" signifient à 10 % près, de préférence à 5 % près.

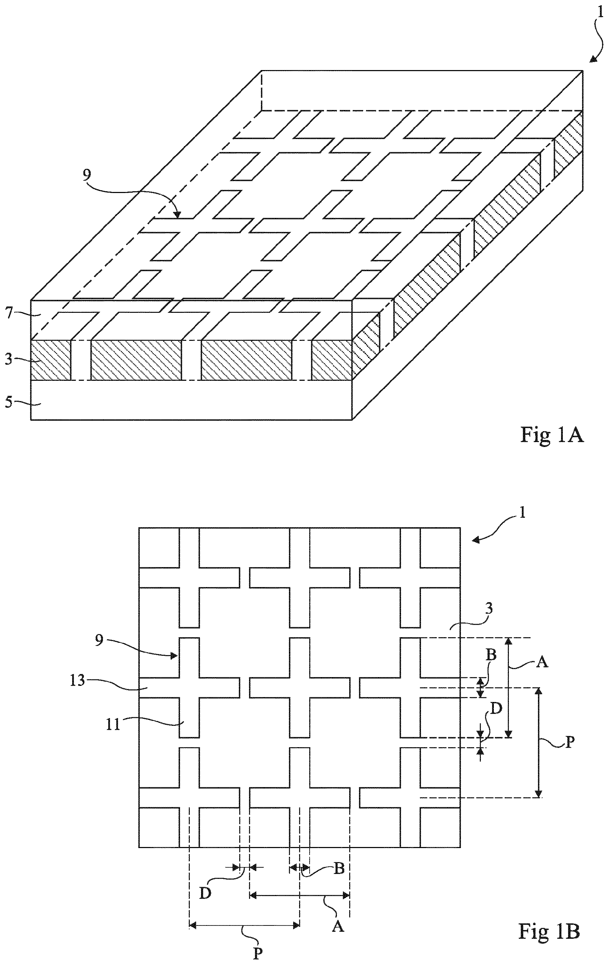

Les figures 1A et 1B représentent schématiquement une portion d'un filtre plasmonique passe-haut dans l'infrarouge. La figure 1A est une vue en coupe et en perspective, et la figure 1B est une vue de dessus.

Le filtre 1 comprend une couche de cuivre 3 intercalée entre deux couches 5 et 7 d'un matériau diélectrique (non représentées en figure 1B). La couche de cuivre 3 est traversée sur toute son épaisseur par des motifs 9 de préférence en le même matériau diélectrique que les couches 5 et 7. Chaque motif 9 a la forme d'une croix grecque, c'est-à-dire d'une croix comportant deux bras 11 et 13 orthogonaux, respectivement de longueur A et de largeur B, ces deux bras se croisant en leurs centres de manière à définir quatre branches ayant sensiblement les mêmes dimensions. Les motifs 9 sont agencés périodiquement dans la couche 3, selon une période P, de manière à former une matrice de motifs 9 dans laquelle les bras 11 des motifs 9 d'une même colonne sont colinéaires et les bras 13 des motifs 9 d'une même ligne sont colinéaires. Ainsi, les bras 11 de motifs 9 adjacents d'une même colonne ont des extrémités en vis-à-vis et les bras 13 de motifs 9 adjacents d'une même ligne ont des extrémités en vis-à-vis. En d'autres termes, les bras 11 et 13 sont alignés respectivement avec d'autres bras 11 et 13. Une distance D, égale à la période P moins la longueur A des bras 11 et 13, sépare les extrémités en vis-à-vis des bras 11 et 13 de motifs 9 adjacents.

On a vu précédemment qu'un filtre plasmonique comprenant des motifs cruciformes en un matériau diélectrique dans une couche métallique tel que décrit dans la demande de brevet WO 2010/029097 est de type passe-bande.

Les inventeurs ont démontré que le filtre des figures 1A et 1B peut être un filtre passe-haut dans l'infrarouge si on se place dans les conditions suivantes :
- la couche métallique 3 est en cuivre et a, de préférence, une épaisseur comprise entre 50 et 500 nm,
- l'indice optique du matériau diélectrique des couches 5 et 7 et des motifs 9 est de préférence compris entre 1,3 et 2,3,
- la distance D est inférieure ou égale à 10 nm, et
- le rapport B/A de la largeur B des bras sur leur longueur A est compris entre 0,3 et 0,6.

Le fait que la couche 3 soit une couche de cuivre constitue une caractéristique du filtre décrit ici. En effet, l'absorption du cuivre, notamment des plasmons du cuivre, est forte dans le visible et faible dans l'infrarouge.

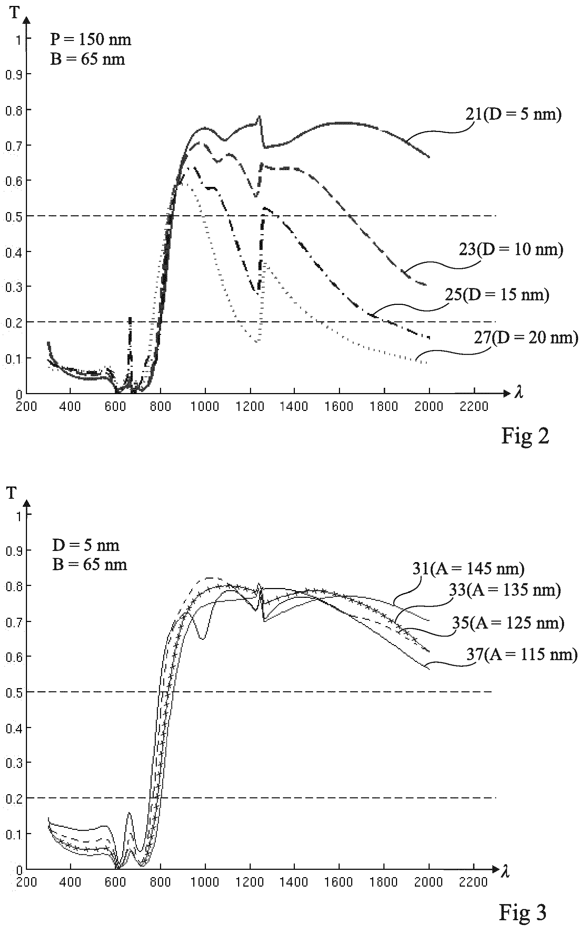

Les conditions susmentionnées pour que le filtre des figures 1A et 1B soit un filtre passe-haut dans l'infrarouge vont maintenant être explicitées en relation avec les figures 2 à 5. Ces figures représentent des courbes illustrant l'influence des paramètres A, B, D et P et de l'indice optique n du matériau diélectrique des motifs 9 et des couches 5 et 7 sur le taux de transmission normalisé d'un filtre du type de celui des figures 1A et 1B. Sauf indication contraire, les filtres utilisés pour obtenir les courbes des figures 2 à 5 ont des motifs 9 et des couches 5 et 7 en nitrure de silicium, une couche de cuivre 3 d'épaisseur égale à 150 nm, une période P égale à 150 nm, et des bras 11 et 13 de largeur B égale à 65 nm et de longueur A égale à 145 nm.

La figure 2 représente quatre courbes 21, 23, 25 et 27 illustrant, pour des filtres plasmoniques du type de celui des figures 1A et 1B, le taux de transmission normalisé T en fonction de la longueur d'onde λ pour diverses valeurs de la distance D.

La courbe 21 correspond à un filtre dans lequel D = 5 nm (A = 145 nm et B/A = 0,45). Pour des longueurs d'onde comprises entre 380 et 780 nm environ, le taux de transmission normalisé T est inférieur à 0,2. A partir d'une longueur d'onde sensiblement égale à 800 nm, T devient supérieur à 0,5. Cette longueur d'onde correspond à la longueur d'onde de coupure du filtre. Pour des longueurs d'onde supérieures à la longueur d'onde de coupure, T est supérieur à 0,6. En particulier, entre 900 nm et 2000 nm, T est sensiblement égal à 0,75.

La courbe 23 correspond à un filtre dans lequel D = 10 nm (A = 135 nm et B/A = 0,48). Comme le filtre de la courbe 21, le filtre de la courbe 23 a un taux de transmission normalisé T inférieur à 0,2 pour des longueurs d'onde comprises entre 380 et 780 nm environ, et une longueur d'onde de coupure sensiblement égale à 800 nm. En revanche, T ne reste supérieur à 0,5 que pour des longueurs d'onde comprises entre la longueur d'onde de coupure et 1700 nm environ. Plus particulièrement, entre 900 et 1500 nm environ, T est supérieur à 0,6.

La courbe 25 correspond à un filtre dans lequel D = 15 nm (A = 125 nm et B/A = 0,52). Le taux de transmission normalisé T est supérieur à 0,5 pour une plage de longueurs d'onde s'étendant de 850 à 1100 nm seulement, et, pour la plupart des longueurs d'onde supérieures à 1100 nm, T est inférieur à 0,4.

La courbe 27 correspond à un filtre dans lequel D = 20 nm (A = 115 nm et B/A = 0,56). Le filtre de la courbe 27 a un taux de transmission normalisé T supérieur à 0,5 pour une plage de longueurs d'onde s'étendant de 850 à 1000 nm seulement, et, pour la plupart des longueurs d'onde supérieures à 1000 nm, T est inférieur à 0,3.

Ainsi, un filtre du type de celui des figures 1A et 1B constitue un filtre passe-haut dans l'infrarouge lorsque D est inférieur ou égal à 10 nm (courbes 23 et 21), de préférence lorsque D est de l'ordre de 5 nm (courbe 21). En revanche, un filtre du type de celui des figures 1A et 1B n'est pas un filtre passe-haut dans l'infrarouge lorsque D est supérieur à 10 nm (courbes 25 et 27).

La figure 3 représente quatre courbes 31, 33, 35 et 37 illustrant, pour des filtres plasmoniques du type de celui des figures 1A et 1B, le taux de transmission normalisé T en fonction de la longueur d'onde λ pour diverses longueurs A des bras 11 et 13. Plus particulièrement, les courbes 31, 33, 35 et 37 correspondent à des filtres dans lesquels la longueur A est égale à 145 nm, 135 nm, 125 nm et 115 nm respectivement, la période P est égale à 150 nm, 140 nm, 130 nm et 120 nm respectivement, et le rapport B/A est égal à 0,45, 0,48, 0,52 et 0,56 respectivement. Comme cela se voit sur la figure 3, les courbes 33, 35 et 37 ont sensiblement la même allure que la courbe 31 qui correspond à la courbe 21 de la figure 2.

Ainsi, dans un filtre du type de celui des figures 1A et 1B, la longueur des bras 11 et 13 des motifs 9 a peu ou pas d'influence sur la réponse du filtre qui reste de type passe-haut dans l'infrarouge dès lors que l'on se place dans les conditions susmentionnées.

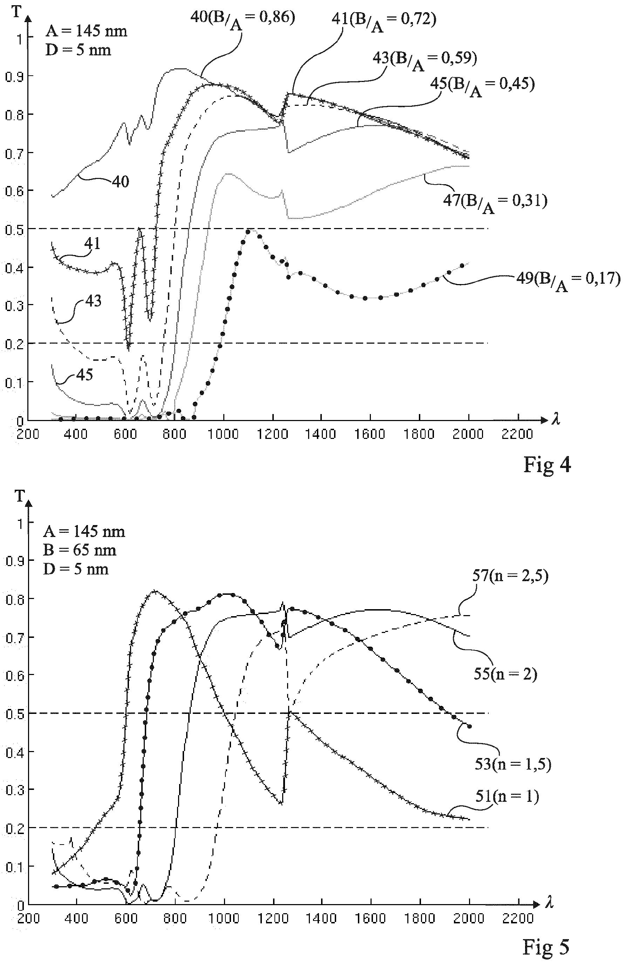

La figure 4 représente six courbes 40, 41, 43, 45, 47 et 49 illustrant, pour des filtres plasmoniques du type de celui des figures 1A et 1B, le taux de transmission normalisé T en fonction de la longueur d'onde λ pour diverses valeurs du rapport B/A de la largeur B sur la longueur A des bras 11 et 13 des motifs cruciformes 9. Les courbes 40, 41, 43, 45, 47 correspondent à des filtres dans lesquels le rapport B/A est égal à 0,86, 0,72, 0,59, 0,45, 0,31 et 0,17, respectivement, c'est-à-dire ici que la largeur B des bras 11 et 13 est égale à 125 nm, 105 nm, 85 nm, 65 nm, 45 nm, et 25 nm respectivement.

Les filtres correspondant aux courbes 40 et 41 (B/A supérieur à 0,6) ont des taux de transmission normalisés T respectifs supérieurs à 0,6 et à 0,3 pour des longueurs d'onde inférieures à 700 nm. Ces filtres laissent donc passer une grande partie de la lumière visible reçue.

Le filtre correspondant à la courbe 49 (B/A inférieur à 0,3) a un taux de transmission normalisé T inférieur à 0,5 pour les longueurs d'onde supérieures à 1000 nm. Ce filtre bloque donc une grande partie de la lumière infrarouge reçue et n'est pas adapté à une utilisation comme filtre passe-haut dans l'infrarouge.

Les filtres correspondant aux courbes 43, 45 et 47, pour lesquels B/A est respectivement égal à 0,59, 0,45 et 0,31, constituent des filtres passe-haut dans l'infrarouge. Plus particulièrement, pour le filtre correspondant à la courbe 43, le taux de transmission normalisé T est inférieur à 0,2 entre 380 et 750 nm environ, la longueur d'onde de coupure est de 780 nm environ, et T est sensiblement constant et égal à 0,8 entre 800 et 2000 nm. Le filtre correspondant à la courbe 45 est le même que le filtre correspondant à la courbe 21 de la figure 2 et les courbes 45 et 21 sont similaires. Pour le filtre correspondant à la courbe 47, T est inférieur à 0,1 entre 380 et 750 nm environ, la longueur d'onde de coupure de 850 nm environ, et T est sensiblement constant et égal à 0,55 entre 850 et 2000 nm.

Ainsi, un filtre du type de celui des figures 1A et 1B constitue un filtre passe-haut dans l'infrarouge lorsque le rapport B/A est compris entre 0,3 et 0,6, les caractéristiques de ce filtre étant meilleures lorsque B/A est compris entre 0,35 et 0,55, par exemple égal à 0,45 (courbe 45). On constate, en outre, que la longueur d'onde de coupure d'un tel filtre augmente quand le rapport B/A diminue.

La figure 5 représente quatre courbes 51, 53, 55 et 57 illustrant, pour des filtres plasmoniques du type de celui des figures 1A et 1B, le taux de transmission normalisé T en fonction de la longueur d'onde λ pour diverses valeurs de l'indice optique n du matériau diélectrique des motifs 9 et des couches 5 et 7. Les courbes 51, 53, 55 et 57 correspondent à des filtres pour lesquels l'indice optique n de ce matériau est égal à 1, 1,5, 2 et 2,5 respectivement, le filtre correspondant à la courbe 55 étant le même que celui correspondant à la courbe 21 de la figure 2.

Le filtre correspondant à la courbe 51 a une longueur d'onde de coupure de 600 nm mais un taux de transmission normalisé T inférieur à 0,5 pour des longueurs d'onde infrarouges supérieures à 900 nm.

Le filtre correspondant à la courbe 57 a une longueur d'onde de coupure de 1000 nm environ. Le taux de transmission normalisé T de ce filtre est supérieur à 0,5 pour des longueurs d'onde supérieures à la longueur d'onde de coupure. Toutefois T est fortement variable pour des longueurs d'onde supérieures à la longueur d'onde de coupure.

Le filtre correspondant à la courbe 53 a une longueur d'onde de coupure de 700 nm environ, un taux de transmission normalisé T inférieur à 0,2 pour des longueurs d'onde inférieures à la longueur d'onde de coupure, et un taux T supérieur à 0,5 pour des longueurs d'onde comprises entre la longueur d'onde de coupure et 1900 nm. Ce filtre est donc adapté à une utilisation comme filtre passe-haut dans l'infrarouge.

Le filtre correspondant à la courbe 55 a une longueur d'onde de coupure de 800 nm environ, un taux de transmission normalisé T inférieur à 0,2 pour des longueurs d'onde inférieures à la longueur d'onde de coupure, et un taux T supérieur à 0,6 pour des longueurs d'onde supérieures à la longueur d'onde de coupure.

Ainsi, pour qu'un filtre du type de celui des figures 1A et 1B constitue un filtre passe-haut dans l'infrarouge, on choisit, de préférence, un matériau diélectrique dont l'indice optique n est compris entre 1,3 et 2,3. On peut choisir comme matériau diélectrique du nitrure de silicium dont l'indice optique n est sensiblement égal à 2.

A titre d'exemple de dimensions, dans un filtre passe-haut dans l'infrarouge du type de celui des figures 1A et 1B :
- l'épaisseur de la couche de cuivre 3 est comprise entre 50 et 500 nm, par exemple égale à 150 nm,
- la période P peut être comprise entre 75 et 200 nm, par exemple égale à 150 nm,
- pour D égal à 5 nm, la longueur A des bras 11 et 13 peut être comprise entre 70 et 195 nm, par exemple égale à 145 nm, et
- la largeur B des bras peut être comprise entre 45 et 85 nm, par exemple égale à 65 nm, quand A est égal à 145 nm, et entre 35 et 65 nm, par exemple 45 nm, quand A est égal à 110 nm.

Plus particulièrement, parmi les différents filtres étudiés, le filtre constituant le meilleur filtre passe-haut dans l'infrarouge est celui des courbes 21, 31, 45 et 55 des figures 2, 3, 4 et 5 respectivement. Dans un tel filtre :
- le matériau diélectrique des motifs 9 et des courbes 5 et 7, par exemple du nitrure de silicium, a un indice optique compris entre 1,3 et 2,3,
- la largeur B des bras 11 et 13, par exemple égale à 65 nm quand la longueur A est égale 145 nm, est telle que le rapport B/A est compris entre 0,35 et 0,55, et
- la distance D est de l'ordre de 5 nm, c'est-à-dire comprise entre 3 et 7 nm.

Le filtre plasmonique des figures 1A et 1B peut être réalisé par un procédé damascène. Une couche de matériau diélectrique dont l'épaisseur correspond à celle de la couche 5 plus celle des motifs 9 est formée. Cette couche est gravée aux emplacements où l'on souhaite former la couche de cuivre 3. Du cuivre est déposé puis retiré jusqu'au matériau diélectrique par gravure aplanissante de manière à laisser en place la couche de cuivre 3 à surface plane. La couche 7 du matériau diélectrique est ensuite déposée.

Un exemple d'application d'un filtre plasmonique du type de celui des figures 1A et 1B va maintenant être décrit.

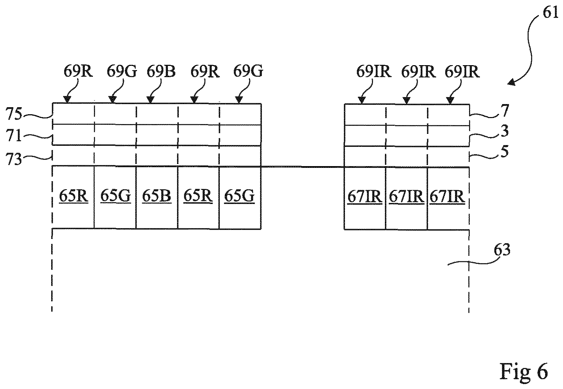

La figure 6 est une vue en coupe représentant schématiquement un exemple d'un capteur d'image comprenant un filtre plasmonique passe-haut dans l'infrarouge du type de celui des figures 1A et 1B.

Le capteur d'image 61 comprend, dans et sur une portion d'une couche semiconductrice 63, par exemple un substrat en silicium, une matrice 65 de pixels 65R, 65G, 65B destinés à recevoir de la lumière visible, et une matrice 67 de pixels 67IR destinés à recevoir de la lumière infrarouge. Les pixels 65R, 65G et 65B sont par exemple destinés à recevoir de la lumière visible respectivement rouge, verte et bleue et peuvent être agencés selon un réseau de Bayer. Bien que, dans cet exemple, la matrice de pixels 65 et la matrice de pixels 67 soient disjointes, les deux matrices de pixels 65 et 67 peuvent aussi constituer une seule et même matrice, les pixels 67IR pouvant alors être régulièrement disposés entre les pixels 65R, 65G et 65B. Chaque pixel 65R, 65G, 65B et 67IR est surmonté d'un filtre 69R, 69G, 69B et 69IR respectivement. Les filtres 69R, 69G, 69B peuvent être des filtres plasmoniques passe-bande, par exemple des filtres du type de ceux de la demande de brevet WO 2010/029097, adaptés à laisser passer la lumière visible, par exemple de la lumière respectivement rouge, verte et bleue. Les filtres 69R comprennent une couche métallique 71 intercalée entre deux couches 73 et 75 d'un matériau diélectrique, la couche métallique 71 étant traversée sur toute son épaisseur par un trou rempli du matériau diélectrique, le trou pouvant être répété périodiquement dans la couche métallique 71. Les filtres 69G, 69B sont par exemple similaires aux filtres 69R à la différence que les dimensions du ou des trous sont choisies en fonction de la lumière que ces filtres laisse passer. Les filtres 69IR sont des filtres plasmoniques du type de celui des figures 1A et 1B comprenant chacun une couche de cuivre 3 intercalée entre deux couches 5 et 7 d'un matériau diélectrique et un motif cruciforme périodique s'étendant à travers toute l'épaisseur de la couche de cuivre 3. Les dimensions des motifs et la période P de répétition des motifs sont choisies pour que les filtres 69IR constituent des filtres passe-haut dans l'infrarouge.

En fonctionnement, le capteur d'image reçoit de la lumière du côté de la face de la couche semiconductrice revêtue des filtres 69R, 69G, 69B et 69IR.

A titre d'exemple, la couche métallique 71 peut être en aluminium, en or, en argent ou en cuivre. Dans le cas où la couche 71 est en cuivre, les couches 71 et 3 peuvent correspondre à des portions d'une même couche de cuivre. Le matériau diélectrique des couches 73 et 75 peut être différent de celui des couches 5 et 7, par exemple de l'oxyde de silicium. Le matériau diélectrique des couches 73 et 75 peut également être le même que celui des couches 5 et 7. Dans ce dernier cas, les couches 73 et 5 peuvent correspondre à des portions d'une même couche, et/ou les couches 7 et 75 peuvent correspondre à des portions d'une même couche.

Ainsi, seule la lumière rouge traverse les filtres 69R et atteint les pixels 65R. De la même manière, seule la lumière bleue atteint les pixels 65B, seule la lumière verte atteint les pixels 65G et seule la lumière infrarouge atteint les pixels 67IR.

Un avantage d'un tel capteur est que les pixels destinés à recevoir la lumière visible et les pixels destinés à recevoir la lumière infrarouge sont réalisés dans et sur une même portion de couche semiconductrice, c'est-à-dire dans et sur une même puce de circuit intégré.

Un autre avantage du capteur est que le filtre passe-haut dans l'infrarouge n'est pas réalisé par de la résine noire ce qui simplifie les étapes de fabrication de ce filtre infrarouge. En particulier, des étapes de fabrication nécessitant des traitements thermiques à des températures supérieures à 250°C peuvent être effectuées après que les filtres 69IR aient été fabriqués. De plus, il est possible de délimiter les filtres infrarouges 69IR sur de petites surfaces correspondant aux pixels 67IR ce qui permet notamment, lorsque les pixels 67IR sont régulièrement disposés parmi les pixels 65R, 65G et 65B, de simplifier la fabrication des filtres 69IR par rapport au cas où de la résine noire est utilisée.

Un autre avantage du capteur est que les filtres 69R, 69B, 69G et 69IR sont fabriqués par des étapes successives de gravure et de dépôt de couches métalliques et isolantes couramment utilisées dans les technologies CMOS. En outre, quand les filtres 69R, 69G, 69B et 69IR sont en les mêmes matériaux, ces derniers peuvent être fabriqués simultanément ce qui simplifie le procédé de fabrication du capteur.

Des modes de réalisation particuliers ont été décrits. Diverses variantes et modifications apparaîtront à l'homme de l'art. En particulier, l'homme du métier pourra adapter les dimensions des motifs 9 et des couches 3, 5 et 7, le matériau des couches 5 et 7, et la période P de manière à modifier la longueur d'onde de coupure, le taux T dans le visible, le taux T pour des longueurs d'onde supérieures à la longueur d'onde de coupure, et l'étendue de la plage de longueurs d'onde dans laquelle le filtre est passant (T supérieur ou égal à 0,5).

Le filtre plasmonique passe-haut dans l'infrarouge décrit précédemment peut être utilisé dans un capteur d'image ne comprenant que des pixels destinés à recevoir de la lumière infrarouge, ou plus généralement dans d'autres dispositifs où l'on souhaite réaliser un filtrage passe-haut dans l'infrarouge.

## Revendications

1. Filtre plasmonique (1) passe-haut dans l'infrarouge comprenant, à travers une couche de cuivre (3) intercalée entre deux couches (5, 7) d'un matériau diélectrique, une matrice de motifs (9) en le matériau diélectrique, chaque motif étant en forme de croix grecque, les bras (11, 13) de motifs adjacents étant colinéaires, le rapport (B/A) de la largeur (B) sur la longueur (A) de chaque bras étant compris entre 0,3 et 0,6, et la distance (D) séparant les extrémités en vis-à-vis de bras de motifs adjacents étant inférieure à 10 nm.

2. Filtre plasmonique selon la revendication 1, dans lequel l'épaisseur de la couche de cuivre (3) est comprise entre 50 et 500 nm.

3. Filtre plasmonique selon la revendication 1 ou 2, dans lequel l'indice optique (n) dudit matériau diélectrique est compris entre 1,3 et 2,3.

4. Filtre plasmonique selon l'une quelconque des revendications 1 à 3, dans lequel le matériau diélectrique est du nitrure de silicium.

5. Filtre plasmonique selon l'une quelconque des revendications 1 à 4, dans lequel la longueur (A) des bras (11, 13) est comprise entre 70 et 195 nm.

6. Filtre plasmonique selon l'une quelconque des revendications 1 à 5, dans lequel ladite distance (D) est comprise entre 3 et 7 nm.

7. Filtre plasmonique selon l'une quelconque des revendications 1 à 6, dans lequel ledit rapport (B/A) est compris entre 0,35 et 0,55.

8. Capteur d'image comprenant, dans et sur une portion de couche semiconductrice, au moins un premier pixel (65R, 65B, 65G) destiné à recevoir de la lumière visible et au moins un deuxième (67IR) pixel destiné à recevoir de la lumière infrarouge, chaque premier pixel étant surmonté d'un filtre plasmonique passe-bande dans le visible (69R, 69B, 69G) et chaque deuxième pixel étant surmonté d'un filtre plasmonique (69IR) selon l'une quelconque des revendications 1 à 7.
